# EUROPEAN PATENT APPLICATION

(11) **EP 4 711 892 A1**
(43) Date of publication of application: **18.03.2026**
(21) Application number: 25195104.2
(22) Date of filing: 11.08.2025
(51) Int. Cl.: G06F 1/16, H05K 7/14

(54) **REDUCTION OF FAN-INDUCED VIBRATION IN ELECTRONIC DEVICES**

(30) Priority: 12.09.2024 US 202418883785
(71) Applicant: INTEL Corporation, Santa Clara, CA 95054 (US)
(72) Inventor: KU, Jeff, 115011 Taipei (TW); ALVA, Samarth, KA 560103 Bangalore (IN); SEN, Arnab, KA 560066 Bangalore (IN); KANIVIHALLI, Raghavendra Subramanya Setty, KA 560037 Bangalore (IN)
(74) Representative: HGF

(57) **Abstract**

Systems, apparatus, articles of manufacture, and methods to reduce fan-induced vibration in electronic devices are disclosed. An example electronic device includes a mainboard; a fan; a chassis including a first cover and a second cover; and
at least two of: (a) a fastener to couple the fan to the chassis; and a first dampener positioned between both (1) the fan and the fastener and (2) the fan and the chassis; (b) a plurality of check valves orientated in a first direction; and
a plurality of inversed check valves oriented in a second direction different than the first direction, the inverse check valves to change a flow rate of air exhausted from the fan; or (c) a first plurality of second dampeners coupled between the mainboard and the first cover; and a second plurality of second dampeners coupled between the mainboard and the second cover.

## Description

### BACKGROUND

Electronic devices such as laptop computers include fans to dissipate heat from the components of the electronic device. The fans can cause vibration on the chassis of the electronic device.

### BRIEF DESCRIPTION OF THE DRAWINGS

FIG. 1A is a cross-sectional view of an example dampener in accordance with teachings of this disclosure.
FIG. 1B is an exploded top view of an example fan assembly to be assembled on an example chassis of an example electronic device with the dampers of FIG. 1A.
FIG. 2A illustrates an example pad with example check valves in accordance with teachings of this disclosure.
FIG. 2B illustrates a top view of a portion of an example electronic device with the pad and check valves of FIG. 2A.
FIG. 2C illustrates a bottom view of a portion of the example electronic device of FIG. 2B with the pad and check valves of FIG. 2A.
FIG. 3A illustrates another example dampener in accordance with teachings of this disclosure.
FIG. 3B illustrates a bottom view of a portion of an example electronic device with the dampeners of FIG. 3A.
FIG. 3C illustrates a top view of a portion of the example electronic device of FIG. 3B with the dampeners of FIG. 3A.
FIG. 3D is a cross-sectional illustration of the electronic device of FIGS. 3B and 3C.
FIG. 3E is an illustration of an example insulator pad.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

Fans in electronic devices, such as laptop computers, may be evacuative designs, hyperbaric designs, or a hybrid hyperbaric design to dissipate heat and cool the electronic device. Mechanical movement so the fans and/or airflow generated by the fans can create vibrations on the chassis (the C-cover and/or the D-cover) and/or on the keys of the keyboard of the electronic device. For example, an imbalanced fan blade may cause vibration. In some examples, a gap between a rotor and a stator may cause vibration. Fans also generate noise, which increases as the rotations per minute (RPM) of the fan increases. The noise, or acoustic level, can also create vibrations. In some examples, such as with hyperbaric designs, the collision of pressurized airflow from fans can generate vibrations. In some examples, the user can sense the vibrations. In some examples, the vibrations are more detectable at higher acoustic levels. In some examples, the magnitude of the vibration increases with fan speed. The vibrations may be most pronounced in the center area of the chassis.

Examples disclosed herein dampen the vibrations. Some examples include dampeners such as viscoelastic dampeners to mount fan housing. Some examples include pads with Tesla valves mounted between one or more internal components of the electronic device and the chassis. Some examples include double layer mounting springs to mount one or more internal components of the electronic device. The different examples disclosed herein can be used individually, all together, and/or in any combination to mitigate vibrations caused by operation of the fans.

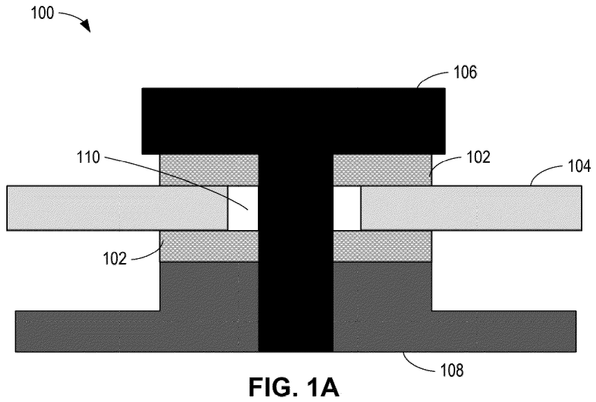

FIG. 1A is a cross-sectional view of an example dampener assembly 100. The dampener assembly 100 includes an example dampener 102. In some examples, the dampener 102 is a viscoelastic dampener. The viscoelastic dampener may be a foam, a rubber, a plastic, a silicone, and/or a combination of materials. In the illustrated example, the dampener 102 is positioned between an example fan mounting tab 104 and an example fastener 106. The fastener 106 secures a fan (via the fan mounting tab 104) to an example mounting boss 108 on a support plate or chassis of an electronic device. The dampener 102 also is positioned between the fan mounting tab 104 and the mounting boss 108. Thus, the dampener 102, in this example, surrounds the fan mounting tab 104. In some examples, there are two dampeners 102, one above the fan mounting tab 104 and one below the fan mounting tab 104. In some examples, the dampener 102 is a single, integral component that is inserted into an aperture 110 of the fan mounting tab 104 and partially positioned above the fan mounting tab 104 and partially positioned below the fan mounting tab 104.

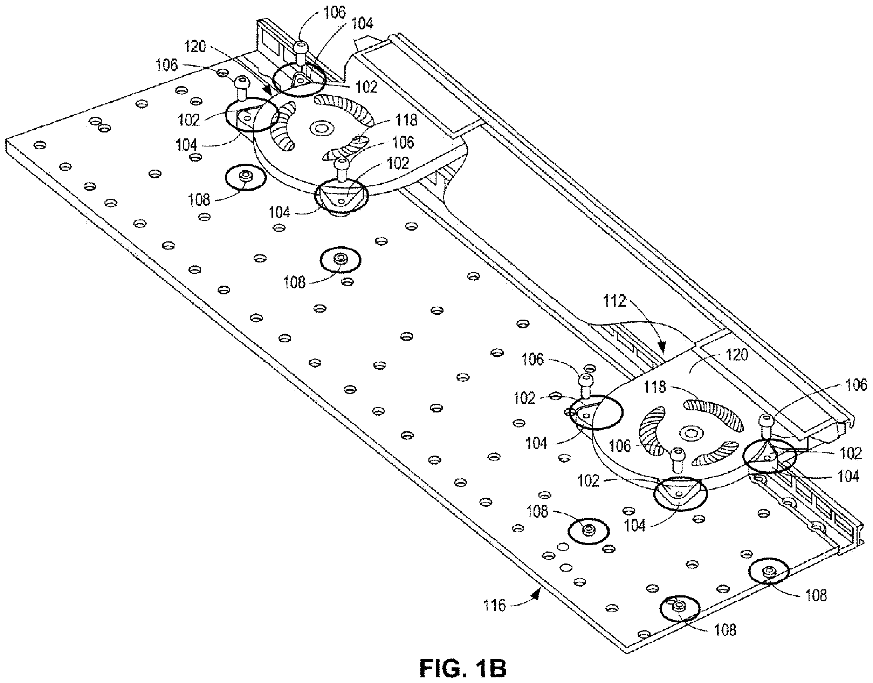

FIG. 1B is an exploded top view of an example fan assembly 112 to be assembled on an example chassis 114 of an example electronic device 116 with the dampers 102 of FIG. 1A. The fan assembly 114 includes an example blower or impeller 118 that has a plurality of fan blades positioned within an example fan housing 120. The fan housing 120 includes a plurality of the fan mounting tabs 104. The fasteners 106 are inserted through the fan mounting tabs 104 and the mounting bosses 108 to hold the fan assembly 112 in position on the chassis 114. The dampeners 102 are positioned in the fan mounting tabs 104.

During operation, the impeller 118 generates airflow to the cool the electronic device 116. Movement of the impeller 118 causes vibrations of the fan housing 120 and the fan mounting tabs 104, which could be conveyed throughout the electronic device 116. The dampeners 102 isolate the fan housing 120 and the fan mounting tabs 104. The dampeners 102 convert mechanical energy from the vibration of the fan housing 120 and the fan mounting tabs 104 into thermal energy, which effectively absorbs the vibration. The dampeners 102 prevent conveyance of propagation of the vibrations from the fan housing 120 and the fan mounting tabs 104 to the fastener 106, the mounting boss 108, and/or the chassis 114. The dampeners 102, thus, isolate vibration from the fan assembly 112 to the chassis 114.

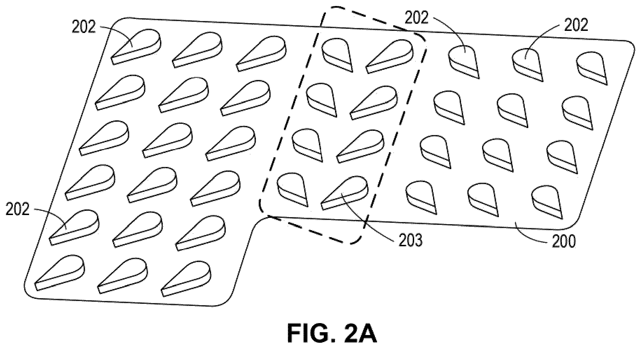

FIG. 2A illustrates an example pad 200 with example check valves 202 that are used to mitigate or dampen vibrations in an electronic device. In some examples, the pad 200 includes rubber. In other examples, the pad 200 includes silicone, plastic, or another material or combination of materials. The pad 200 acts as a cushion.

In some examples, the check valves 202 are valvular conduits such as Tesla valves. The check valves 202 allow air generated from fans of an electronic device to an opening or outlet. The check valves 202 in the center of the pad 202 are oriented in a direction different from the check valves 202 at the right and left sides of the pad 200. The check valves 202 that are oriented differently may be called reversed or inversed check valves 203. The illustrated example show two rows of inversed check valves 203. Other examples may include other numbers of rows such as one, three, four, etc. In some examples, the tips of the check valves in adjacent rows are separated a first distance, and the tips of inversed check valves in adjacent rows are separated a second distance, the second distance less than the first distance. In some examples, the first distance is about 8 millimeters (mm), and the second distance is about 2 mm.

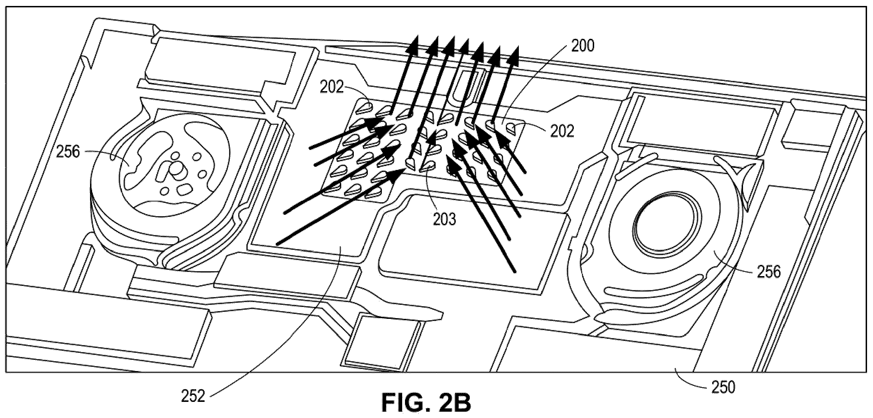

FIG. 2B illustrates a top view of a portion of a portion of an example electronic device 250 with the pad 200 and the check valves 202 and inversed check valves 203. In the example of FIG. 2B, the portion of the electronic device 250 shown in the area between a mainboard 252 and a C-cover of a laptop computer. In this example, the pad 200 is coupled to the mainboard 252. The pad 200 and the check valves 202 and the inversed check valves 203 extend between the main board 252 and the C-cover.

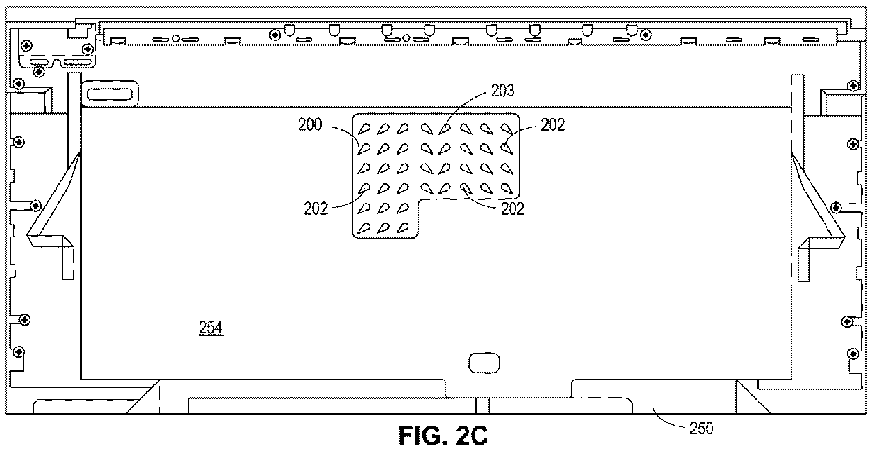

FIG. 2C illustrates a bottom view of a portion of the example electronic device 250 of FIG. 2B with the pad 200 and the check valves 202 and inversed check valves 203. In the example of FIG. 2C, the portion of the electronic device 250 shown in the area between the mainboard 252 and a D-cover of a laptop computer. The pad 200 on the bottom of the electronic device is coupled to an example thermal module 254. The thermal module 254 may include one or more of heatsinks, plates, vapor chambers, heat pipes, etc. In some examples, the pad 200 is coupled to copper pillar sections of a vapor chamber that forms the thermal module 254. The pad 200 and the check valves 202 and the inversed check valves 203 extend between the thermal module 254 and the D-cover.

The inverse check valves 203 are placed in the center of the pad 200 for flow velocity reduction to minimize vibration created from the collision of air flowing from the fans 256 (FIG. 2B). The area with the check valves 202 to the side of the pad 200 are high flow areas. The area in with the inverse check valves 203 in the center of the pad 200 is a low flow area. In other words, air exhausted from the fans 256 has a first flow rate around the check valves 202. Air exhausted from the fans 256 has a second flow rate around the inversed check valves 203. The first flow rate is greater than the second flow rate.

With the flow velocity reduced in the center of the electronic device 250, which corresponds to the center of a keyboard, the magnitude of vibration caused by the air collision is reduced. The check valves 202 and the inverse check valves 203 do not create obstacles that affect the overall flowrate because the size outlet opening size of the electronic 250 has not changed. Air continues to flow to the outlet, but in a diverted manner around the check valves 202 and the inverse check valves 203 to reduce or avoid collision of the two flow streams from the fans 256.

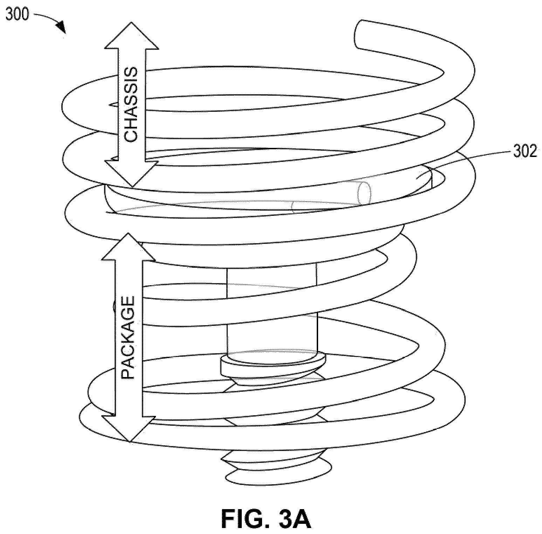

FIG. 3A illustrates another example dampener 300. The dampener 300 in this example is a conical spring. In some examples, the conical spring has coils in a center portion with a first diameter and coils at an edge portion with a second diameter, the second diameter greater than the first diameter. The dampener 300 is positioned around an example fastener 302 that secures internal components of an electronic device. The dampener 300 extends on two sides of the fastener 302. In the illustrated example, one side of the dampener 300 buffers against a chassis of the electronic device, and the other side of the dampener 300 buffers against a package or mainboard of the electronic device. The package as used herein includes a central processing unit (CPU), a graphics processing unit (GPU), etc.

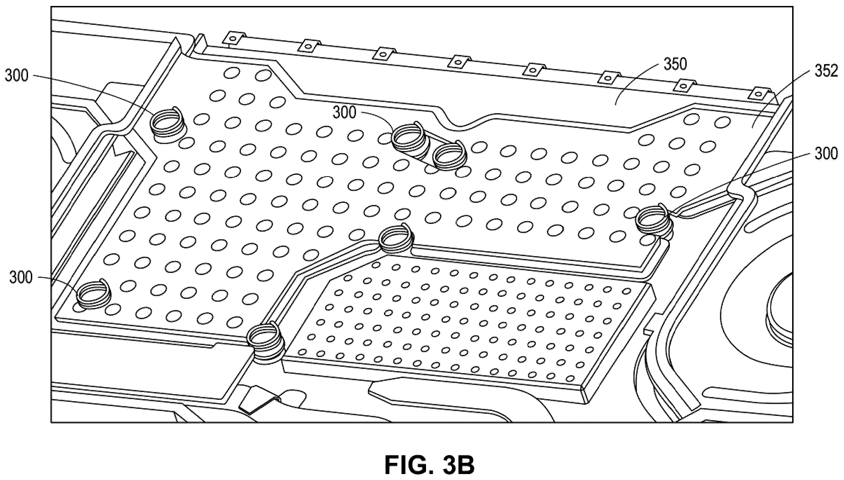

FIG. 3B illustrates a bottom view of a portion of an example electronic device 350 with the dampeners 300 of FIG. 3A. The electronic device 350 includes an example thermal module 352. The thermal module 352 may include one or more of heatsinks, plates, vapor chambers, heat pipes, etc.

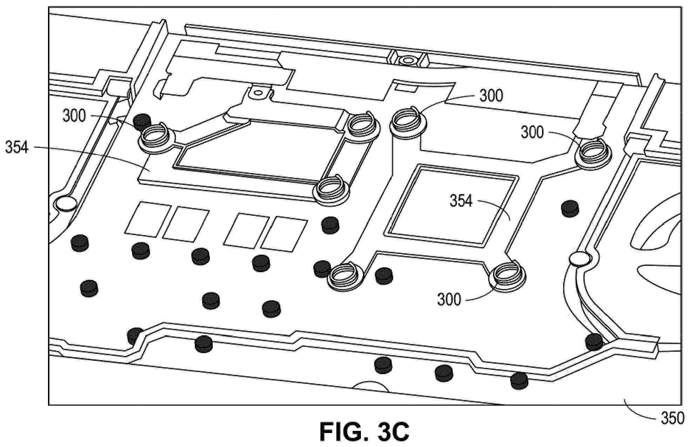

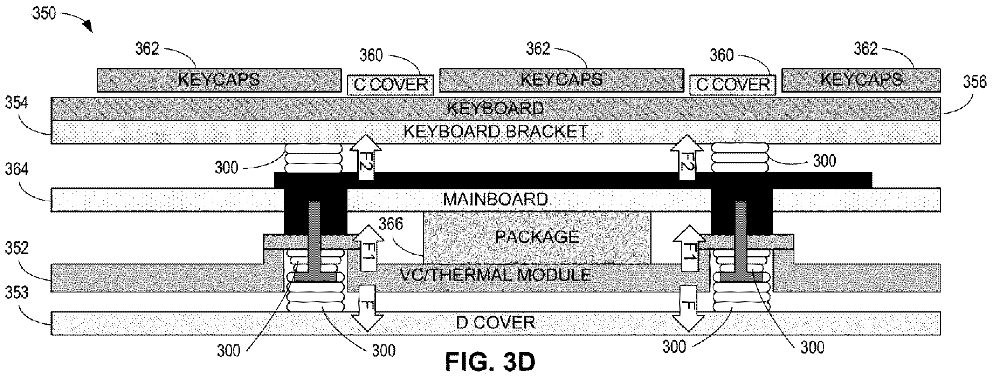

FIG. 3C illustrates a top view of a portion of the example electronic device 350 of FIG. 3B with additional the dampeners 300. The additional dampeners 300 of FIG. 3C are coupled to an example keyboard bracket 354. In the illustrated example the keyboard bracket 354 is two components. In other examples, the keyboard bracket 354 may be one component, three components, etc. In the illustrated example of FIG. 3B, there are seven dampeners 300 that are axially aligned to balance reaction forces that are applied to the keyboard 356 and a D cover 358 (FIG. 3D).

FIG. 3D is a cross-sectional illustration of the electronic device 350 of FIGS. 3B and 3C. The electronic device 350 includes the D-cover 358 and a C-cover 360. The C-cover 360 surrounds the keyboard 356 and keycaps 362 of the keys of the keyboard 356. As disclosed above, one or more dampeners 300 are positioned between the D-cover 358 and the thermal module 352 (FIGS. 3B and 3D). The dampeners 300 extend on both side of the fasteners 302 that couple the thermal module 352 to a mainboard 364 that supports a package 366. The dampeners 300 form a double-layer mounting that applies loads in two directions (F, F1). One direction (F) is to the chassis and/or D-cover 258. The second direction (F1) is to the mainboard 364 and/or package 366.

The electronic device 350 also includes the dampeners 300 between the mainboard 364 and the keyboard bracket 354 (FIGS. 3C and 3D) that apply a load (F2). In some examples, there are corresponding dampeners 300 coupled to the keyboard bracket 354 as to those dampeners 300 coupled to the thermal module to counteract the reaction force generated by the fasteners 302. The inclusion of corresponding dampeners 300 maintains balanced load distribution.

The dampeners 300 absorb mechanical movements of the internal components of the electronic device 350 that may be cause by use of the keyboard 356 or by fan-induced vibrations such as vibrations caused by the collision of air flow, mechanical vibrations from fan operation, and/or acoustic vibrations from fan noise.

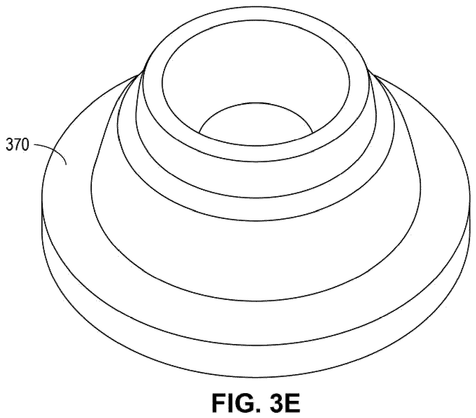

In some examples, an insulator pad 370 (FIG. 3E) is included at one end (e.g., in the upper turn) of the dampeners 300 to reduce heat conduction to the chassis (the C-cover 360 and the D-cover 358). In some examples, the insulator pads 370 may include a thermal isolation rubber or other flexible material that would further dampen vibrations.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

From the foregoing, it will be appreciated that example systems, apparatus, articles of manufacture, and methods have been disclosed that reduce fan induced vibration in electronic device. The example disclosed herein do not affect outbound flow rate of exhaust air used to cool the electronic devices. In addition, examples disclosed herein do not affect skin temperature of the electronic devices. Disclosed systems, apparatus, articles of manufacture, and methods are accordingly directed to one or more improvement(s) in the operation of a machine such as a computer or other electronic and/or mechanical device.

Example systems, apparatus, articles of manufacture, and methods have been disclosed that reduce fan induced vibration in electronic device include Example 1 includes an electronic device that includes a fan; a chassis; a fastener to couple the fan to the chassis; and a dampener positioned between both (1) the fan and the fastener and (2) the fan and the chassis.

Example 2 includes the electronic device of Example 1, wherein the fan includes a fan mounting tab, and the dampener is positioned between both (1) the fan mounting tab and the fastener and (2) the fan mounting tab and the chassis.

Example 3 includes the electronic device of Example, wherein the dampener is an integral component that is inserted into an aperture of the fan mounting tab to be positioned partially above the fan mounting tab and partially below the fan mounting tab.

Example 4 includes the electronic device of any of Examples 1-3, wherein the chassis includes a mounting boss, and the dampener is positioned between both (1) the fan and the fastener and (2) the fan and the mounting boss.

Example 5 includes the electronic device of any of Examples 1-4, wherein the dampener is to convert mechanical energy from the fan into thermal energy during operation of the fan.

Example 6 includes an electronic device that includes a fan; a chassis; a plurality of check valves orientated in a first direction; and a plurality of inversed check valves oriented in a second direction different than the first direction, the inverse check valves to change a flow rate of air exhausted from the fan.

Example 7 includes the electronic device of Example 6, wherein air exhausted from the fan has a first flow rate around the plurality of check valves and second flow rate around the plurality of inversed check valves, the first flow rate greater than the second flow rate.

Example 8 includes the electronic device of any of Examples 6-7, further including: a cover; a mainboard; and a pad, the plurality of check valves and the plurality of inversed check valves coupled to the pad, the pad and the plurality of check valves and the plurality of inversed check valves to extend between the mainboard and the cover.

Example 9 includes the electronic device of any of Examples 6-8, further including: a cover; a thermal module; and a pad, the plurality of check valves and the plurality of inversed check valves coupled to the pad, the pad and the plurality of check valves and the plurality of inversed check valves to extend between the thermal module and the cover.

Example 10 includes the electronic device of any of Examples 6-9, further including: a mainboard; a thermal module; a first pad coupled to the mainboard, a first set of the check valves coupled to the first pad, a first set of the inversed check valves coupled to the first pad; and a second pad coupled to the thermal module, a second set of the check valves coupled to the second pad, a second set of the inversed check valves coupled to second first pad.

Example 11 includes the electronic device of any of Examples 6-10, wherein two of the plurality of check valves are separated a first distance, and two of the plurality of inversed check valves are separated a second distance, the second distance less than the first distance.

Example 12 includes an electronic device that includes a first cover; a second cover; a mainboard; a first plurality of dampeners coupled between the mainboard and the first cover; and a second plurality of dampeners coupled between the mainboard and the second cover.

Example 13 includes the electronic device of Example 12, further including: a thermal module; and a plurality of fasteners to couple the thermal module to the mainboard, wherein respective dampeners of the second plurality of dampeners have a first portion between the second cover and a respective fastener and a second portion between the respective fastener and the mainboard.

Example 14 includes the electronic device of Example 13, further including an insulator pad between respective ones of the second plurality of dampeners and the thermal module.

Example 15 includes the electronic device of any of Examples 12-14, wherein the first plurality of dampeners are aligned with the second plurality of dampeners.

Example 16 includes the electronic device of any of Examples 12-15, wherein the first plurality of dampeners and the second plurality of dampeners include conical springs.

Example 17 includes the electronic device of Example 16, wherein respective ones of the conical springs have coils in a center portion with a first diameter and coils at an edge portion with a second diameter, the second diameter greater than the first diameter.

Example 18 includes an electronic device that includes a mainboard; a fan; a chassis including a first cover and a second cover; and at least two of: (a) a fastener to couple the fan to the chassis; and a first dampener positioned between both (1) the fan and the fastener and (2) the fan and the chassis; (b) a plurality of check valves orientated in a first direction; and a plurality of inversed check valves oriented in a second direction different than the first direction, the inverse check valves to change a flow rate of air exhausted from the fan; or (c) a first plurality of second dampeners coupled between the mainboard and the first cover; and a second plurality of second dampeners coupled between the mainboard and the second cover.

Example 19 includes the electronic device of Example 18, wherein the fan includes a fan mounting tab, and the first dampener is positioned between both (1) the fan mounting tab and the fastener and (2) the fan mounting tab and the chassis.

Example 20 includes the electronic device of Example 19, wherein the first dampener is an integral component that is inserted into an aperture of the fan mounting tab to be positioned partially above the fan mounting tab and partially below the fan mounting tab.

Example 21 includes the electronic device of any of Examples 18-20, wherein the chassis includes a mounting boss, and the first dampener is positioned between both (1) the fan and the fastener and (2) the fan and the mounting boss.

Example 22 includes the electronic device of any of Examples 18-21, wherein the first dampener is to convert mechanical energy from the fan into thermal energy during operation of the fan.

Example 23 includes the electronic device of any of Examples 18-22, wherein air exhausted from the fan has a first flow rate around the plurality of check valves and second flow rate around the plurality of inversed check valves, the first flow rate greater than the second flow rate.

Example 24 includes the electronic device of any of Examples 18-23, further including a pad, the plurality of check valves and the plurality of inversed check valves coupled to the pad, the pad and the plurality of check valves and the plurality of inversed check valves to extend between the mainboard and the first cover.

Example 25 includes the electronic device of any of Examples 18-24, further including: a thermal module; and a pad, the plurality of check valves and the plurality of inversed check valves coupled to the pad, the pad and the plurality of check valves and the plurality of inversed check valves to extend between the thermal module and the second cover.

Example 26 includes the electronic device of any of Examples 18-25, further including: a thermal module; a first pad coupled to the mainboard, a first set of the check valves coupled to the first pad, a first set of the inversed check valves coupled to the first pad; and a second pad coupled to the thermal module, a second set of the check valves coupled to the second pad, a second set of the inversed check valves coupled to second first pad.

Example 27 includes the electronic device of any of Examples 18-26, wherein two of the plurality of check valves are separated a first distance, and two of the plurality of inversed check valves are separated a second distance, the second distance less than the first distance.

Example 28 includes the electronic device of any of Examples 18-27, further including: a thermal module; and a plurality of fasteners to couple the thermal module to the mainboard, wherein respective dampeners of the second plurality of second dampeners have a first portion between the second cover and a respective fastener and a second portion between the respective fastener and the mainboard.

Example 29 includes the electronic device of any of Examples 18-28, further including an insulator pad between respective ones of the second plurality of second dampeners and the thermal module.

Example 30 includes the electronic device of any of Examples 18-29, wherein the first plurality of second dampeners are aligned with the second plurality of second dampeners.

Example 31 includes the electronic device of any of Examples 18-30, wherein the first plurality of second dampeners and the second plurality of second dampeners include conical springs.

Example 32 includes the electronic device of Examples 31, wherein respective ones of the conical springs have coils in a center portion with a first diameter and coils at an edge portion with a second diameter, the second diameter greater than the first diameter.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An electronic device comprising:
a mainboard;
a fan;
a chassis including a first cover and a second cover; and
at least two of:
(a) a fastener to couple the fan to the chassis; and
a first dampener positioned between both (1) the fan and the fastener and (2) the fan and the chassis;
(b) a plurality of check valves orientated in a first direction; and
a plurality of inversed check valves oriented in a second direction different than the first direction, the inverse check valves to change a flow rate of air exhausted from the fan; or
(c) a first plurality of second dampeners coupled between the mainboard and the first cover; and
a second plurality of second dampeners coupled between the mainboard and the second cover.

2. The electronic device of claim 1, wherein the fan includes a fan mounting tab, and the first dampener is positioned between both (1) the fan mounting tab and the fastener and (2) the fan mounting tab and the chassis.

3. The electronic device of claim 2, wherein the first dampener is an integral component that is inserted into an aperture of the fan mounting tab to be positioned partially above the fan mounting tab and partially below the fan mounting tab.

4. The electronic device of any of claims 1-3, wherein the chassis includes a mounting boss, and the first dampener is positioned between both (1) the fan and the fastener and (2) the fan and the mounting boss.

5. The electronic device of any of claims 1-4, wherein the first dampener is to convert mechanical energy from the fan into thermal energy during operation of the fan.

6. The electronic device of any of claims 1-5, wherein air exhausted from the fan has a first flow rate around the plurality of check valves and second flow rate around the plurality of inversed check valves, the first flow rate greater than the second flow rate.

7. The electronic device of any of claims 1-6, further including a pad, the plurality of check valves and the plurality of inversed check valves coupled to the pad, the pad and the plurality of check valves and the plurality of inversed check valves to extend between the mainboard and the first cover.

8. The electronic device of any of claims 1-7, further including:
a thermal module; and
a pad, the plurality of check valves and the plurality of inversed check valves coupled to the pad, the pad and the plurality of check valves and the plurality of inversed check valves to extend between the thermal module and the second cover.

9. The electronic device of any of claims 1-7, further including:
a thermal module;
a first pad coupled to the mainboard, a first set of the check valves coupled to the first pad, a first set of the inversed check valves coupled to the first pad; and
a second pad coupled to the thermal module, a second set of the check valves coupled to the second pad, a second set of the inversed check valves coupled to second first pad.

10. The electronic device of any of claims 1-9, wherein two of the plurality of check valves are separated a first distance, and two of the plurality of inversed check valves are separated a second distance, the second distance less than the first distance.

11. The electronic device of any of claims 1-10, further including:
a thermal module; and
a plurality of fasteners to couple the thermal module to the mainboard, wherein respective dampeners of the second plurality of second dampeners have a first portion between the second cover and a respective fastener and a second portion between the respective fastener and the mainboard.

12. The electronic device of claim 11, further including an insulator pad between respective ones of the second plurality of second dampeners and the thermal module.

13. The electronic device of any of claims 1-12, wherein the first plurality of second dampeners are aligned with the second plurality of second dampeners.

14. The electronic device of any of claims 1-13, wherein the first plurality of second dampeners and the second plurality of second dampeners include conical springs.

15. The electronic device of claim 14, wherein respective ones of the conical springs have coils in a center portion with a first diameter and coils at an edge portion with a second diameter, the second diameter greater than the first diameter.
